(19) Europäisches Patentamt / European Patent Office / Office européen des brevets

(11) **EP 3 920 244 B1**

(12) **FASCICULE DE BREVET EUROPEEN**

(45) Date de publication et mention
de la délivrance du brevet:
**04.01.2023 Bulletin 2023/01**

(51) Classification Internationale des Brevets (IPC):
*H01L 31/107* (2006.01)  *H01L 31/11* (2006.01)
*H01L 31/112* (2006.01)

(21) Numéro de dépôt: **21177706.5**

(52) Classification Coopérative des Brevets (CPC):
**H01L 31/1075; H01L 31/1105; H01L 31/1129**

(22) Date de dépôt: **04.06.2021**

(54) **PHOTOTRANSISTOR A HETEROJONCTION COMPRENANT UNE COUCHE D'AVALANCHE**

HETEROÜBERGANG-PHOTOTRANSISTOR MIT EINER AVALANCHE-SCHICHT

HETEROJUNCTION PHOTOTRANSISTOR COMPRISING AN AVALANCHE LAYER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **04.06.2020 FR 2005826**

(43) Date de publication de la demande:
**08.12.2021 Bulletin 2021/49**

(73) Titulaire: **THALES
92400 Courbevoie (FR)**

(72) Inventeur: **ACHOUCHE, Mohand
91767 Palaiseau (FR)**

(74) Mandataire: **Atout PI Laplace
Immeuble "Visium"
22, avenue Aristide Briand
94117 Arcueil Cedex (FR)**

(56) Documents cités:
**EP-A1- 2 200 096    CN-A- 103 545 398
CN-A- 107 302 037    CN-A- 109 285 914
JP-A- H05 275 730    US-A1- 2004 227 155**

## Description

### Domaine technique :

La présente invention concerne le domaine des phototransistors et plus particulièrement des phototransistors à hétérojonction.

### Technique antérieure :

Un phototransistor à hétérojonction (HPT) est un composant semi-conducteur possédant une très forte sensibilité à la lumière incidente. Les phototransistors possèdent un grand nombre d'application dans les opto-isolateurs, dans la détection de position, dans des capteurs à haute sensibilité...

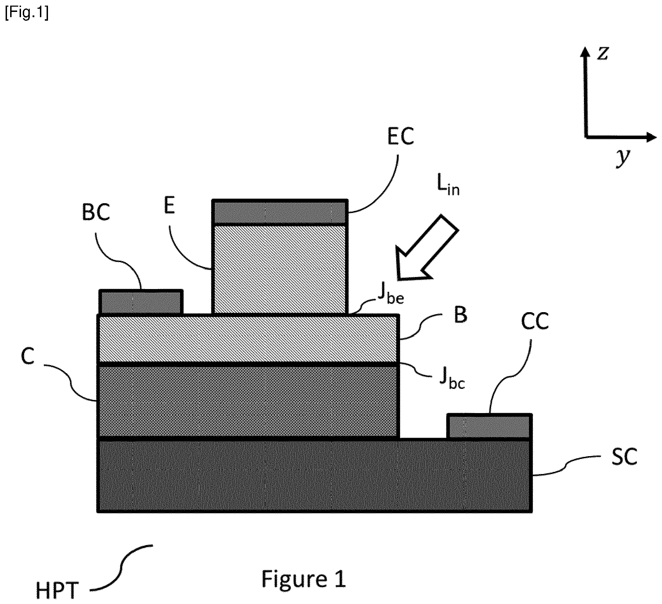

La figure 1 illustre un phototransistor à hétérojonction HPT de l'art antérieur comprenant un empilement selon un axe z de quatre couches déposées sur un substrat : une couche inférieure sous collectrice SC (servant de contact à la couche collectrice C), une couche collectrice C, une couche de base B, une couche émettrice E ainsi que trois électrodes : une électrode collectrice CC, une électrode de base BC et une électrode émettrice EC. Ce composant permet d' amplifier un photocourant circulant depuis une électrode collectrice CC jusqu'à une électrode émettrice EC, le photocourant provenant du flux lumineux $L_{in}$ absorbé par une couche de base B. La sensibilité élevée au flux lumineux du phototransistor provient du gain du transistor, généralement appelé β, à l'origine de l'amplification. Un phototransistor est similaire à un transistor classique à l'exception que sa couche de base B est sensible à la lumière.

Un phototransistor convertit des photons d'énergie supérieure à la largeur de bande interdite (ou gap) $E_b$ de la couche de base B en porteurs de charges photogénérés dans la jonction couche de base-couche collectrice $J_{bc}$.

Dans le cas d'un phototransistor NPN, c'est-à-dire une couche émettrice E dopée N, une couche de base dopée P et une couche collectrice dopée N, les électrons générés par l'absorption des photons incidents sont injectés dans la couche collectrice créant ainsi un courant dit photocourant $I_{ph}$ circulant de la couche collectrice à la couche de base.

Dans le cas où, la jonction couche de base-couche collectrice est polarisée en inverse (donc lorsque la différence de tension entre l'électrode de base et l'électrode de collection est négative) ce photocourant est amplifié par le gain du transistor β. Ce gain de transistor est contrôlé par la polarisation entre l'électrode émettrice et l'électrode de base.

Dans le cas d'un phototransistor NPN, une différence de tension positive entre l'électrode de base BC et l'électrode émettrice EC va polariser en direct la jonction PN $J_{be}$ à l'interface entre couche de base-couche émettrice. Les électrons excités thermiquement de la couche émettrice vont être injectés vers la couche de base puis vont diffuser au travers de la couche de base vers la couche collectrice créant ainsi un courant dit courant jonction PN $I_j$ lui aussi amplifié par le gain de transistor. Dans le cas d'un phototransistor NPN, les électrons sont les porteurs de charge minoritaires car la base est dopée P.

La couche de base étant dopée P, il est important de limiter l'épaisseur de cette couche afin de limiter le taux de recombinaison des électrons (porteurs de charge minoritaires dans la couche de base) se diffusant dans la base vers la couche collectrice avec les trous (porteurs de charge majoritaires). Pour cela, la couche de base est moins dopée que la couche émettrice et possède une épaisseur très inférieure à la longueur de diffusion des électrons.

La jonction couche collectrice-couche de base $J_{bc}$ est en outre polarisée en inverse pour qu'il n'y ait quasiment aucune injection d'électrons depuis la couche collectrice vers la couche de base. Ainsi, les porteurs de charge injectés ou photogénérés dans la couche de base et diffusant jusqu'à atteindre la région de déplétion de la jonction couche de base-couche collectrice sont injectés dans la couche collectrice grâce au champ électrique dans cette région.

Le courant total $I_c$ circulant dans le dispositif vaut :
$I_c = \beta I_j + Gopt I_{ph} + I_{ph,p}$; avec $I_{ph,p}$ le photocourant primaire correspondant à la conversion optique/électrique en l'absence de gain.

Le paramètre limitant le temps de réponse d'un phototransistor est l'épaisseur de la couche de base et de la couche collectrice. Plus ces épaisseurs sont importantes, plus le temps de transit des porteurs de charges dans ces couches et plus le temps de réponse sont élevés. Afin de diminuer le temps de réponse d'un phototransistor il est donc avantageux de diminuer l'épaisseur de la couche de base et de la couche collectrice. Cependant, cette diminution entraine en contrepartie une diminution de la responsivité du phototransistor quand il fonctionne en mode photodétecteur. On rappelle ici que la responsivité mesure le courant électrique en sortie du phototransistor en fonction de la puissance optique d'entrée.

Afin d'augmenter la responsivité d'un phototransistor sans diminuer le temps de réponse, il est connu d'illuminer latéralement un HPT avec un guide d'onde optique (Magnin, V., et al. "A three-terminal edge-coupled InGaAs/InP heterojunction phototransistor for multifunction operation." Microwave and Optical Technology Letters 17.6 (1998): 408-412.). Cependant cet arrangement expérimental ne permet qu'une faible augmentation de la responsivité (jusqu'à 0.29 A/W).

Des structures complexes résonantes de phototransistor permettent d'améliorer l'efficacité quantique, cependant cette amélioration se fait au détriment du temps de réponse (limité à 20 GHz pour Prakash, D. P., et al. "Integration of polyimide waveguides with traveling-wave phototransistors." IEEE Photonics Technology Letters 9.6 (1997): 800-802.).

Il est connu de réaliser un phototransistor à deux électrodes fonctionnant en régime d'avalanche dans la couche collectrice grâce à l'application d'un forte tension de polarisation inverse (Campbell, J., et al. "Avalanche InP/InGaAs heterojunction phototransistor." IEEE Journal of Quantum Electronics 19.6 (1983): 1134-1138.). Cependant, l'utilisation de deux électrodes ne permet pas l'injection d'un courant $I_j$ de jonction base-émettrice et limite le gain. Le document JP H05 275730 A décrit un phototransistor à hétérojoncton, comme celui connu dans l'état de la technique.

L'invention vise à pallier certains problèmes de l'art antérieur. A cet effet, un objet de l'invention est un phototransistor à hétérojonction comprenant au moins une couche d'avalanche permettant d'améliorer la responsivité du phototransistor sans diminuer son temps de réponse.

### Résumé de l'invention :

Un objet de l'invention est donc un phototransistor à hétérojonction à avalanche comprenant un empilement de couches semi-conductrices au-dessus d'un substrat comprenant:

- une couche inférieure de l'empilement, dite couche sous-collectrice dopée N+ ;

- une couche collectrice dopée N, le dopage de la couche collectrice étant inférieur à un dopage de la couche sous-collectrice ;

- une couche de base dopée P et présentant un gap $E_b$ inférieur à un gap de ladite couche collectrice $E_c$, ladite couche de base étant configurée pour absorber un rayonnement lumineux à une énergie supérieure ou égale audit gap de la couche de base de manière à générer un courant dit photo-courant ;

- une couche supérieure dite couche émettrice dopée N, présentant un gap supérieur au gap de la couche de base ;

le phototransistor comprenant de plus :

- une électrode émettrice, dopée N +, disposée au-dessus de ladite couche émettrice;

- une électrode de base disposée au-dessus de la couche de base, une différence de tension positive entre l'électrode de base et l'électrode émettrice polarisant en direct la jonction couche émettricecouche de base et génèrant un courant dit courant jonction PNcirculant de la couche de base vers la couche de émettrice ;

- une électrode collectrice disposée au-dessus de la couche sous-collectrice, une différence de tension négative entre l'électrode de base et l'électrode de collection permettant une circulation du photocourant de la couche collectrice vers la couche de base et la multiplication du photocourant par un gain dit gain transistor $\beta$ ;

ledit phototransisor étant caractérisé en ce qu'il comprend en outre un ensemble de couches semi-conductrices successives, disposé entre la couche collectrice et la couche de base comprenant :

- une couche supérieure de l'ensemble dite couche graduelle dopée N;

- une couche disposée en dessous de la couche graduelle, dite couche de charge écran dopée P+ ;

- une couche disposée en dessous de la couche écran, présentant un même matériau que la couche écran, dite couche d'avalanche, non dopée et de gap $E_{av}$ supérieur au gap de la couche de base $E_b$ et supérieur au gap de la couche collectrice $E_c$ ;

- une couche disposée en dessous de la couche d'avalanche, présentant un même matériau que la couche écran, dite couche d'injection dopée N+, présentant une épaisseur au moins 10 fois inférieure à une épaisseur de ladite couche d'avalanche;

ladite couche graduelle étant configurée pour présenter un gap graduel de manière à diminuer la barrière de potentiel à l'interface entre la couche de base et la couche de charge écran,

ladite couche écran étant configurée pour localiser un champ électrique élevé dans la couche d'avalanche;

ladite couche à avalanche étant configurée pour générer un gain d'avalanche $M$, additionnel au gain transistor $\beta$ et au gain de conversion optique / électrique Gopt, multipliant le photocourant lors d'une application de ladite différence de tension négative entre l'électrode de base et l'électrode de collection ;

ladite couche d'injection étant adaptée pour faciliter le transport de charges entre la couche d'avalanche et la couche collectrice.

Selon des modes particuliers de l'invention :

- l'électrode émettrice est en InGaAs ou InGaAsP ou Si et possède une densité de dopage comprise entre $0.5 \times 10^{18} cm^{-3}$ et $1.5 \times 10^{19} cm^{-3}$ et une épaisseur comprise entre 80nm et 120nm ;

- la couche émettrice est en InP ou GaInAsP ou Al-

GaInAs ou Si et possède une densité de dopage comprise entre $0.5 \times 10^{16} cm^{-3}$ et $1.5 \times 10^{17} cm^{-3}$ et une épaisseur comprise entre 120nm et 180nm ;

- la couche de base est en InGaAs, SiGe ou Si, possède une densité de dopage comprise entre $0.5 \times 10^{18} cm^{-3}$ et $1.5 \times 10^{19} cm^{-3}$ et une épaisseur comprise entre 40nm et 100nm ;

- la couche graduelle est en InGaAlAs ou InGaAsP ou Si, possède une densité de dopage comprise entre $0.5 \times 10^{18} cm^{-3}$ et $1.5 \times 10^{18} cm^{-3}$ et une épaisseur comprise entre 40nm et 100nm ;

- la couche écran est en InAlAs ou Si ou InP, possède une densité de dopage comprise entre $0.5 \times 10^{17} cm^{-3}$ et $1.5 \times 10^{18} cm^{-3}$ et une épaisseur comprise entre 40nm et 60nm ;

- la couche avalanche est en InAlAs ou Si ou InAlGaAs et une épaisseur comprise entre 160nm et 500nm ;

- la couche d'injection est en InAlAs ou Si ou InAlGaAs, possède une densité de dopage comprise entre $0.5 \times 10^{17} cm^{-3}$ et $1.5 \times 10^{18} cm^{-3}$ et une épaisseur comprise entre 4nm et 6nm ;

- la couche collectrice est en InGaAsP, InGaAlAs, InP, Si ou SiGe, possède une densité de dopage comprise entre $10^{15} cm^{-3}$ et $10^{16} cm^{-3}$ et une épaisseur comprise entre 800nm et 1200nm ;

- la couche sous collectrice est en InP ou Si, possède une densité de dopage comprise entre $10^{18} cm^{-3}$ et $10^{19} cm^{-3}$ et une épaisseur comprise entre 400nm et 600nm

## Brève description des figures :

D'autres caractéristiques, détails et avantages de l'invention ressortiront à la lecture de la description faite en référence aux dessins annexés donnés à titre d'exemple et qui représentent, respectivement :

[Fig. 1] une vue schématique d'un phototransistor de l'art antérieur.

[Fig.2] une vue schématique d'un phototransistor à hétérojonction à avalanche selon l'invention.

Dans les figures, sauf contre-indication, les éléments ne sont pas à l'échelle.

## Description détaillée :

Dans la suite, on considère un dopage N (respectivement P) comme un dopage d'une densité d'électrons (respectivement de trous) comprise entre $5 \times$ $10^{14} cm^{-3}$ et $10^{17} cm^{-3}$ et un dopage N+ (respectivement P+) comme un dopage d'une densité d'électrons (respectivement de trous) supérieur à $5 \times 10^{17} cm^{-3}$.

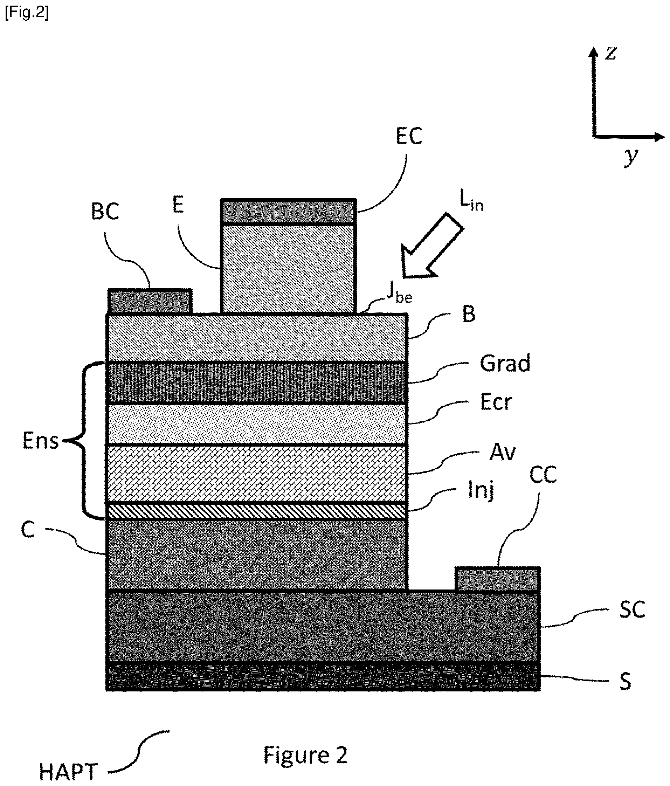

La figure 2 illustre un phototransistor à hétérojonction à avalanche HAPT selon l'invention. Le phototransistor selon l'invention comprend un empilement de couches semi-conductrices au-dessus d'un substrat S comprenant une couche inférieure de l'empilement, dite couche sous-collectrice SC dopée N+. Cette couche sous-collectrice sert de contact N au phototransistor de l'invention.

L'empilement comprend une couche collectrice C dopée N, le dopage de la couche collectrice étant inférieur au dopage de la couche sous-collectrice. La couche collectrice de l'invention est réalisée dans un matériau présentant un gap intermédiaire $E_c$ (typiquement compris entre 1eV et 1.35eV).

L'empilement comprend une couche de base B dopée P et présentant un gap inférieur au gap de ladite couche collectrice, ladite couche de base étant configurée pour absorber un rayonnement lumineux à une énergie supérieure ou égale audit gap de la couche de base $E_b$ de manière à générer un courant dit photo-courant $I_{ph}$. La couche de base de l'invention est réalisée dans un matériau présentant un gap faible $E_b$ (typiquement inférieur à 0.8eV) afin de permettre une bonne mobilité des porteurs de charge en fonctionnement transistor du phototransistor et afin de permettre une absorption efficace d'un rayonnement incident IR en fonctionnement photodiode.

De plus, l'empilement comprend une couche supérieure dite couche émettrice E dopée N, présentant un gap élevé, supérieur au gap de la couche de base (typiquement supérieur ou égal à 1 eV).

Le phototransistor de l'invention comprend de plus une électrode émettrice EC au-dessus de ladite couche émettrice et une électrode de base BC disposée au-dessus de la couche de base. Comme mentionné précédemment, une différence de tension positive entre l'électrode de base et l'électrode émettrice polarise en direct la jonction couche émettrice- couche de base $J_{be}$ et génère un courant jonction PN $I_j$ circulant de la couche de base vers la couche de émettrice.

Le phototransistor de l'invention comprend en outre une électrode de collection CC disposée au-dessus de la couche sous-collectrice. Le phototransistor est adapté pour qu'une différence de tension négative entre l'électrode de base et l'électrode de collection polarise en inverse la jonction couche collectrice et couche de base $J_{bc}$, permettant ainsi une circulation du courant jonction PN et du photocourant de la couche collectrice vers la couche de base et la multiplication du photocourant par un gain dit gain transistor $\beta$. Le gain de transistor est contrôlé par la polarisation entre l'électrode émettrice et l'électrode base.

Selon un mode de réalisation de l'invention, les électrodes du phototransistor sont métalliques. Alternativement, selon un autre mode de réalisation de l'invention, l'électrode émettrice est réalisée dans un matériau semi-conducteur dopé N+ avec une densité de dopage N plus élevée, préférentiellement 10 fois, encore préférentiellement 100 fois supérieure à celle de la couche de base.

Le phototransistor de l'invention diffère de l'art antérieur en ce qu'il comprend en outre un ensemble Ens de couches semi-conductrices successives, disposé entre la couche collectrice et la couche de base. Cet ensemble comprend :

- une couche supérieure de l'ensemble dite couche graduelle Grad non dopée ;

- une couche disposée en dessous de la couche graduelle, dite couche de charge écran Ecr dopée P+ ;

- une couche disposée en dessous de la couche écran, présentant un même matériau que la couche écran, dite couche d'avalanche (Av), non dopée et de gap $E_{av}$ très élevé (typiquement supérieur à 1.35eV), supérieur au gap de la couche de base $E_b$ et supérieur ou égal au gap de la couche collectrice $E_c$ ;

- une couche disposée en dessous de la couche d'avalanche, présentant un même matériau que la couche écran, dite couche d'injection Inj dopée N+, présentant une épaisseur au moins 10 fois inférieure à une épaisseur de ladite couche d'avalanche.

La couche à avalanche est configurée pour générer un gain d'avalanche M, qui vient s'ajouter au gain transistor $\beta$ et au gain de conversion optique/électrique, multipliant le photocourant lors d'une application d'une différence de tension négative entre l'électrode de base et l'électrode de collection.

Ainsi, le courant total circulant dans le phototransistor de l'invention $I_c$ vaut :

$$I_c = \beta I_j + (Gopt + M)I_{ph} + I_{ph,p}.$$

Le phénomène d'avalanche, utilisé dans les photodiodes à avalanche par exemple, apparait lorsque le champ électrique au sein de la couche d'avalanche -et donc la polarisation inverse de la jonction PN couche collectrice-couche de base $J_{bc}$- est suffisamment élevée. Alors, le champ électrique est suffisamment important pour accélérer les électrons et les trous photogénérés et pour générer d'autres paires électrons-trous par ionisation par impact électronique lorsqu'ils percutent des atomes de la couche d'avalanche, qui eux-mêmes vont générer d'autres paires électrons-trous par le même mécanisme avant de diffuser vers la couche collectrice. Ainsi, les électrons et les trous photogénérés (et donc le photocourant) sont multipliés par le gain d'avalanche M généré par la couche d'avalanche et le champ électrique présent au sein de cette couche. Le matériau de la couche d'avalanche utilisé devra favoriser une ionisation par les électrons grâce à son coefficient d'ionisation des électrons (Alpha) supérieur à celui des trous (Béta).

La structure formée par l'ensemble de couches Ens -avec une couche d'avalanche intrinsèque et de gap élevé $E_{av}$-, la couche de base fortement dopée P et la couche collectrice dopée N possède un fonctionnement similaire à une diode PIN à avalanche de l'art antérieur avec une couche intrinsèque multiplicatrice.

Une couche d'avalanche telle qu'utilisée dans les photodiodes à avalanche de l'art antérieur n'est pas directement transposable dans le phototransistor de l'invention car le fonctionnement en phototransistor nécessite l'ajout d'une couche d'injection et une couche de collection des porteurs. Les inventeurs ont mis au point l'ensemble de couches interdépendantes précité permettant un fonctionnement optimisé de la couche à avalanche au sein du phototransistor de l'invention.

Selon un mode de réalisation de l'invention, la différence de tension entre l'électrode de base et l'électrode de collection est inférieure à - 5 V. Cette valeur est donnée à titre d'exemple et est dépendante du dopage de la couche écran.

La couche graduelle de l'empilement est configurée pour présenter un gap graduel de manière à diminuer la barrière de potentiel à l'interface entre la couche de base B et la couche écran Ecr. Comme mentionné précédemment, la couche à avalanche (et donc la couche écran qui possède la même structure et présentant le même matériau que la couche à avalanche) possède un grand gap. Aussi, la couche graduelle permet de faciliter l'injection des électrons dans la couche d'avalanche depuis la couche de base et celle des trous secondaires générés par le phénomène d'avalanche qui doivent rejoindre la couche de base où ceux-ci sont majoritaires.

La couche écran est une couche adaptée pour répartir le champ électrique entre la couche de base et la couche d'avalanche. Plus précisément, la couche écran possède un dopage P+ configuré pour distribuer un champ électrique élevé dans la couche d'avalanche et un champ électrique modéré dans la couche de base. Ici, par champ électrique élevé on entend un champ supérieur à 400 kV/cm et par champ électrique modéré on entend un champ compris entre 75 kV/cm et 150kV/cm. Le champ électrique élevé dans la couche d'avalanche permet de générer des paires électrons-trous par l'ionisation par impact électronique et le gain d'avalanche M du phototransistor de l'invention. De plus, cette couche écran permet de diminuer le courant de fuite du phototransistor de l'invention.

La couche d'injection est une couche possédant un dopage N+ de type *delta*-doping (plan de dopage) adaptée pour faciliter le transport des porteurs de charge entre la couche d'avalanche et la couche collectrice. En effet, les porteurs de charge provenant de la couche d'avalanche possèdent une énergie élevée, aussi, afin de faciliter leur transport vers une couche collectrice possédant un gap intermédiaire, il est nécessaire d'introduire cette couche d'injection afin d'écranter le champ électrique présent dans la couche d'avalanche et d'obtenir un champ modéré dans la couche collectrice. Elle permet de plus d'utiliser une couche collectrice de gap intermédiaire permettant de réduire la capacitance du phototransistor de l'invention en créant une zone désertée dans la couche collectrice sous un champ électrique. Cela permet donc de diminuer le produit RC (résistance-capacitance) limitant la bande-passante et donc d'améliorer le produit gain-bande passante du phototransistor de l'invention.

Du fait de l'existence du gain additionnel M, le phototransistor de l'invention possède une responsivité améliorée par rapport aux phototransistors de l'art antérieur sans augmentation de l'épaisseur de la couche collectrice et de la couche de base et donc sans diminution du temps de réponse, par le biais de l'ensemble de couche Ens. Cela est rendu possible par l'utilisation d'une couche d'avalanche donnant une amplification additionnelle du photocourant $I_{ph}$ et par l'implémentation judicieuse de cette couche dans l'ensemble de couches semi-conductrices du phototransistor de l'invention.

Selon un mode de réalisation de l'invention, la couche collectrice est réalisée dans un matériau présentant un gap compris entre le gap du matériau de la couche de base et le gap du matériau de la couche d'avalanche.

Selon un mode de réalisation de l'invention, l'électrode émettrice est en InGaAs ou InGaAsP ou Si et possède une densité de dopage comprise entre $0.5 \times 10^{18}cm^{-3}$ et $1.5 \times 10^{19}cm^{-3}$ et une épaisseur comprise entre 50nm et 120nm. Alternativement, selon un autre mode de réalisation, l'électrode émettrice est une électrode métallique.

Selon un mode de réalisation de l'invention, la couche émettrice est en InP ou GaInAsP ou AlGaInAs ou Si, possède une densité de dopage comprise entre $0.5 \times 10^{16}cm^{-3}$ et $1.5 \times 10^{17}cm^{-3}$ et une épaisseur comprise entre 120nm et 180nm.

Selon un mode de réalisation de l'invention, la couche de base est en InGaAs, SiGe ou Si, possède une densité de dopage comprise entre $0.5 \times 10^{18}cm^{-3}$ et $1.5 \times 10^{19}cm^{-3}$ et une épaisseur comprise entre 40nm et 100nm. Une couche de base de faible épaisseur permet de réduire le temps de réponse du phototransistor de l'invention.

Selon un mode de réalisation de l'invention, la couche graduelle est en InGaAlAs ou InGaAsP ou Si, possède une densité de dopage comprise entre $0.5 \times 10^{18}cm^{-3}$ et $1.5 \times 10^{18}cm^{-3}$ et une épaisseur comprise entre 40nm et 100nm.

Selon un mode de réalisation de l'invention, la couche écran est en InAlAs ou Si ou InP, possède une densité de dopage comprise entre $0.5 \times 10^{17}cm^{-3}$ et $1.5 \times 10^{18}cm^{-3}$ et une épaisseur comprise entre 40nm et 60nm.

Selon un mode de réalisation de l'invention, la couche avalanche est en InAlAs ou Si ou InAlGaAs et a une épaisseur comprise entre 160nm et 500nm. La couche d'avalanche n'est pas dopée et présente un bandgap très élevé (typiquement supérieur à 1.35eV) afin de permettre un gain d'avalanche important.

Selon un mode de réalisation de l'invention, la couche d'injection est en InAlAs ou Si ou InAlGaAs, possède une densité de dopage comprise entre $0.5 \times 10^{17}cm^{-3}$ et $1.5 \times 10^{18}cm^{-3}$ et une épaisseur comprise entre 4nm et 6nm.

Selon un mode de réalisation de l'invention, la couche collectrice est en InGaAsP, InGaAlAs, InP, Si ou SiGe, possède une densité de dopage comprise entre $10^{15}cm^{-3}$ et $10^{16}cm^{-3}$ et une épaisseur comprise entre 800nm et 1200nm.

Selon un mode de réalisation de l'invention, la couche sous collectrice est en InP ou Si, possède une densité de dopage comprise entre $10^{18}cm^{-3}$ et $10^{19}cm^{-3}$ et une épaisseur comprise entre 400nm et 600nm.

## Revendications

1. Phototransistor à hétérojonction à avalanche (HAPT) comprenant un empilement de couches semi-conductrices au-dessus d'un substrat (S) comprenant:

   - une couche inférieure de l'empilement, dite couche sous-collectrice (SC) dopée N+ ;
   - une couche collectrice (C) dopée N, le dopage de la couche collectrice étant inférieur à un dopage de la couche sous-collectrice ;
   - une couche de base (B) dopée P et présentant un gap $E_b$ inférieur à un gap de ladite couche collectrice $E_c$, ladite couche de base étant configurée pour absorber un rayonnement lumineux à une énergie supérieure ou égale audit gap de la couche de base de manière à générer un courant dit photo-courant ($I_{ph}$) ;
   - une couche supérieure dite couche émettrice (E) dopée N, présentant un gap supérieur au gap de la couche de base ;

   le phototransistor comprenant de plus :

   - une électrode émettrice (EC), dopée N +, disposée au-dessus de ladite couche émettrice (E) ;
   - une électrode de base (BC) disposé au-dessus de la couche de base, une différence de tension positive entre l'électrode de base et l'électrode émettrice polarisant en direct la jonction couche émettricecouche de base ($J_{be}$) et génèrant un courant dit courant jonction PN ($I_j$) circulant de la couche de base vers la couche de émettrice ;
   - une électrode collectrice (CC) disposée au-dessus de la couche sous-collectrice, une différence de tension négative entre l'électrode de base et l'électrode de collection permettant une circulation du photocourant de la couche collectrice vers la couche de base et la multiplication du photocourant par un gain dit gain transistor $\beta$ ;

ledit phototransisor étant **caractérisé en ce qu'**il comprend en outre un ensemble de couches semi-conductrices successives (Ens), disposé entre la couche collectrice et la couche de base comprenant :

- une couche supérieure de l'ensemble dite couche graduelle (Grad) dopée N;
- une couche disposée en dessous de la couche graduelle, dite couche de charge écran (Ecr) dopée P+ ;
- une couche disposée en dessous de la couche écran, présentant un même matériau que la couche écran, dite couche d'avalanche (Av), non dopée et de gap $E_{av}$ supérieur au gap de la couche de base $E_b$ et supérieur au gap de la couche collectrice $E_c$ ;
- une couche disposée en dessous de la couche d'avalanche, présentant un même matériau que la couche écran, dite couche d'injection (Inj) dopée N+, présentant une épaisseur au moins 10 fois inférieure à une épaisseur de ladite couche d'avalanche;

ladite couche graduelle étant configurée pour présenter un gap graduel de manière à diminuer la barrière de potentiel à l'interface entre la couche de base (B) et la couche de charge écran (Ecr),

ladite couche écran étant configurée pour localiser un champ électrique élevé dans la couche d'avalanche (Av) ;

ladite couche à avalanche étant configurée pour générer un gain d'avalanche $M$, additionnel au gain transistor $\beta$ et au gain de conversion optique / électrique Gopt, multipliant le photocourant lors d'une application de ladite différence de tension négative entre l'électrode de base et l'électrode de collection ;

ladite couche d'injection étant adaptée pour faciliter le transport de charges entre la couche d'avalanche et la couche collectrice.

2. Phototransistor selon la revendication précédente dans lequel l'électrode émettrice est en InGaAs ou InGaAsP ou Si et possède une densité de dopage comprise entre $0.5 \times 10^{18}cm^{-3}$ et $1.5 \times 10^{19}cm^{-3}$ et une épaisseur comprise entre 50nm et 120nm.

3. Phototransistor selon l'une quelconque des revendications précédentes dans lequel la couche émettrice est en InP ou GaInAsP ou AlGaInAs ou Si, possède une densité de dopage comprise entre $0.5 \times 10^{16}cm^{-3}$ et $1.5 \times 10^{17}cm^{-3}$ et une épaisseur comprise entre 120nm et 180nm.

4. Phototransistor selon l'une quelconque des revendications précédentes dans lequel la couche de base est en InGaAs, SiGe ou Si, possède une densité de dopage comprise entre $0.5 \times 10^{18}cm^{-3}$ et $1.5 \times 10^{19}cm^{-3}$ et une épaisseur comprise entre 40nm et 100nm.

5. Phototransistor selon l'une quelconque des revendications précédentes dans lequel la couche graduelle est en InGaAlAs ou InGaAsP ou Si, possède une densité de dopage comprise entre $0.5 \times 10^{18}cm^{-3}$ et $1.5 \times 10^{18}cm^{-3}$ et une épaisseur comprise entre 40nm et 100nm ;

6. Phototransistor selon l'une quelconque des revendications précédentes dans lequel la couche écran est en InAlAs ou Si ou InP, possède une densité de dopage comprise entre $0.5 \times 10^{17}cm^{-3}$ et $1.5 \times 10^{18}cm^{-3}$ et une épaisseur comprise entre 40nm et 60nm.

7. Phototransistor selon l'une quelconque des revendications précédentes dans lequel la couche avalanche est en InAlAs ou Si ou InAlGaAs et une épaisseur comprise entre 160nm et 500nm.

8. Phototransistor selon l'une quelconque des revendications précédentes dans lequel la couche d'injection est en InAlAs ou Si ou InAlGaAs, possède une densité de dopage comprise entre $0.5 \times 10^{17}cm^{-3}$ et $1.5 \times 10^{18}cm^{-3}$ et une épaisseur comprise entre 4nm et 6nm.

9. Phototransistor selon l'une quelconque des revendications précédentes dans lequel la couche collectrice est en InGaAsP, InGaAlAs, InP ou SiGe, possède une densité de dopage comprise entre $10^{15}cm^{-3}$ et $10^{16}cm^{-3}$ et une épaisseur comprise entre 800nm et 1200nm.

10. Phototransistor selon l'une quelconque des revendications précédentes, dans lequel la couche sous collectrice est en InP ou Si, possède une densité de dopage comprise entre $10^{18}cm^{-3}$ et $10^{19}cm^{-3}$ et une épaisseur comprise entre 400nm et 600nm.

**Patentansprüche**

1. Phototransistor mit Lawinen-Heteroübergang (HAPT), der einen Stapel von Halbleiterschichten über einem Substrat (S) umfasst, der Folgendes umfasst:

- eine untere Schicht des Stapels, N+ dotierte Subkollektorschicht (SC) genannt;
- eine N-dotierte Kollektorschicht (C), wobei die Dotierung der Kollektorschicht geringer ist als die Dotierung der Subkollektorschicht;
- eine Basisschicht (B), die mit P dotiert ist und eine $E_b$-Lücke aufweist, die kleiner ist als eine Lücke der Kollektorschicht $E_c$, wobei die Basisschicht zum Absorbieren von Lichtstrahlung mit einer Energie gleich der oder größer als die Lücke der Basisschicht konfiguriert ist, um einen Photostrom ($I_{ph}$) genannten Strom zu erzeugen;
- eine N-dotierte Emissionsschicht (E) genannte obere Schicht mit einer Lücke, die größer ist als die Lücke der Basisschicht;

wobei der Fototransistor ferner Folgendes umfasst:

- eine N+ dotierte Emissionselektrode (EC), die über der Emissionsschicht (E) angeordnet ist;
- eine Basiselektrode (BC), die über der Basisschicht angeordnet ist, wobei eine positive Spannungsdifferenz zwischen der Basiselektrode und der Emissionselektrode den Emissionsschicht-Basisschicht-Übergang ($J_{be}$) in Durchlassrichtung polarisiert und einen PN-Übergangsstrom ($I_j$) genannten Strom erzeugt, der von der Basisschicht zur Emissionsschicht fließt;
- eine Kollektorelektrode (CC), die über der Subkollektorschicht angeordnet ist, wobei eine negative Spannungsdifferenz zwischen der Basiselektrode und der Kollektorelektrode den Fluss des Photostroms von der Kollektorschicht zur Basisschicht und die Multiplikation des Photostroms mit einer Transistorverstärkung $\beta$ genannten Verstärkung ermöglicht;

wobei der Fototransistor **dadurch gekennzeichnet ist, dass** er ferner einen Satz von aufeinanderfolgenden Halbleiterschichten (Ens) umfasst, die zwischen der Kollektorschicht und der Basisschicht angeordnet sind und Folgendes umfassen:

- eine obere Schicht des Satzes, N-dotierte gradierte Schicht (Grad) genannt;
- eine unter der gradierten Schicht angeordnete Schicht, P+ dotierte Abschirmungsladungsschicht (Ecr) genannt;
- eine unter der Abschirmungsschicht angeordnete Schicht aus dem gleichen Material wie die Abschirmungsschicht, Lawinenschicht (Av) genannt, nicht dotiert und mit einer Lücke $E_{av}$, die größer als die Lücke der Basisschicht $E_b$ und größer als die Lücke der Kollektorschicht $E_c$ ist;
- eine unter der Lawinenschicht angeordnete Schicht aus dem gleichen Material wie die Abschirmungsschicht, N+ dotierte Injektionsschicht (Inj) genannt, deren Dicke mindestens 10-mal geringer ist als die Dicke der Lawinenschicht;
- wobei die gradierte Schicht so konfiguriert ist, dass sie eine gradierte Lücke aufweist, um die Potentialbarriere an der Grenzfläche zwischen der Basisschicht (B) und der Abschirmungsladungsschicht (Ecr) zu verringern,

wobei die Abschirmungsschicht so konfiguriert ist, dass sie ein hohes elektrisches Feld in der Lawinenschicht (Av) lokalisiert;
wobei die Lawinenschicht zum Erzeugen einer Lawinenverstärkung M, zusätzlich zur Transistorverstärkung $\beta$ und zur optischen/elektrischen Umwandlungsverstärkung Gopt, konfiguriert ist, die bei Anlegen der negativen Spannungsdifferenz zwischen der Basiselektrode und der Kollektorelektrode den Photostrom vervielfacht;
wobei die Injektionsschicht zum Erleichtern des Ladungstransports zwischen der Lawinenschicht und der Kollektorschicht ausgelegt ist.

2. Phototransistor nach dem vorherigen Anspruch, wobei die Emissionselektrode aus InGaAs oder InGaAsP oder Si besteht und eine Dotierungsdichte zwischen $0,5 \times 10^{18}$ cm$^{-3}$ und $1,5 \times 10^{19}$ cm$^{-3}$ und eine Dicke zwischen 50 nm und 120 nm aufweist.

3. Phototransistor nach einem der vorherigen Ansprüche, wobei die Emissionsschicht aus InP oder GaInAsP oder AlGaInAs oder Si besteht, eine Dotierungsdichte zwischen $0,5 \times 10^{16}$ cm$^{-3}$ und $1,5 \times 10^{17}$ cm$^{-3}$ und eine Dicke zwischen 120 nm und 180 nm aufweist.

4. Fototransistor nach einem der vorherigen Ansprüche, wobei die Basisschicht aus InGaAs, SiGe oder Si besteht, eine Dotierungsdichte zwischen $0,5 \times 10^{18}$ cm$^{-3}$ und $1,5 \times 10^{19}$ cm$^{-3}$ und eine Dicke zwischen 40 nm und 100 nm aufweist.

5. Phototransistor nach einem der vorherigen Ansprüche, wobei die gradierte Schicht aus InGaAlAs oder InGaAsP oder Si besteht, eine Dotierungsdichte zwischen $0,5 \times 10^{18}$ cm$^{-3}$ und $1,5 \times 10^{18}$ cm$^{-3}$ und eine Dicke zwischen 40 nm und 100 nm aufweist.

6. Phototransistor nach einem der vorherigen Ansprüche, wobei die Abschirmungsschicht aus InAlAs oder Si oder InP besteht, eine Dotierungsdichte zwischen $0,5 \times 10^{17}$ cm$^{-3}$ und $1,5 \times 10^{18}$ cm$^{-3}$ und eine Dicke zwischen 40 nm und 60 nm aufweist.

7. Phototransistor nach einem der vorherigen Ansprüche, wobei die Lawinenschicht aus InAlAs oder Si oder InAlGaAs besteht und eine Dicke zwischen 160 nm und 500 nm aufweist.

8. Phototransistor nach einem der vorherigen Ansprüche, wobei die Injektionsschicht aus InAlAs oder Si oder InAlGaAs besteht, eine Dotierungsdichte zwischen $0,5 \times 10^{17}$ cm$^{-3}$ und $1,5 \times 10^{18}$ cm$^{-3}$ und eine Dicke zwischen 4 nm und 6 nm aufweist.

9. Phototransistor nach einem der vorherigen Ansprüche, wobei die Kollektorschicht aus InGaAsP, InGaAlAs, InP oder SiGe besteht, eine Dotierungsdichte zwischen $10^{15}$ cm$^{-3}$ und $10^{16}$ cm$^{-3}$ und eine Dicke zwischen 800 nm und 1200 nm aufweist.

10. Phototransistor nach einem der vorherigen Ansprüche, wobei die Subkollektorschicht aus InP oder Si besteht, eine Dotierungsdichte zwischen $10^{18}$ cm$^{-3}$ und $10^{19}$ cm$^{-3}$ und eine Dicke zwischen 400 nm und 600 nm aufweist.

## Claims

1. A heterojunction avalanche phototransistor (HAPT) comprising a stack of semi-conductive layers above a substrate (S) comprising:

   - a lower layer of the stack, referred to as an N+ doped sub-collection layer (SC);
   - an N-doped collection layer (C), the doping of the collection layer being less than a doping of the sub-collection layer;
   - a P-doped base layer (B) which has a gap $E_b$ less than a gap of the collection layer $E_c$, the base layer being configured to absorb light radiation at an energy which is greater than or equal to the gap of the base layer in order to generate a current referred to as a photocurrent ($I_{ph}$);
   - an upper layer, referred to as an N-doped emitter layer (E), which has a gap greater than the gap of the base layer;
   the phototransistor further comprising:

   - an N+ doped emitter electrode (EC) which is arranged above the emitter layer (E);
   - a base electrode (BC) which is arranged above the base layer, a positive voltage difference between the base electrode and the emitter electrode directly polarising the emitter layer/base layer junction ($J_{be}$) and generating a current referred to as a junction current PN ($I_j$) which circulates from the base layer to the emitter layer;
   - a collection electrode (CC) which is arranged above the sub-collection layer, a negative voltage difference between the base electrode and the collection electrode enabling a circulation of the photocurrent from the collection layer to the base layer and the multiplication of the photocurrent by a gain referred to as a transistor gain β;
   - the phototransistor being **characterised in that** it further comprises an assembly of successive semi-conductive layers (Ens) which is arranged between the collection layer and the base layer, comprising:

   - an upper layer of the assembly referred to as an N-doped graded layer (Grad);
   - a layer which is arranged below the graded layer referred to as a P+ doped screen charge layer (Ecr);
   - a layer which is arranged below the screen layer and which has the same material as the screen layer, referred to as a non-doped avalanche layer (Av) with a gap $E_{av}$ which is greater than the gap of the base layer $E_b$ and greater than the gap of the collection layer ($E_c$);
   - a layer which is arranged below the avalanche layer and which has the same material as the screen layer, which is referred to as an N+ doped injection layer (Inj) and which has a thickness at least 10 times less than a thickness of the avalanche layer;

   the graded layer being configured to have a graded gap in order to reduce the potential barrier at the interface between the base layer (B) and the screen charge layer (Ecr),
   the screen layer being configured to locate a high electrical field in the avalanche layer (Av);
   the avalanche layer being configured to generate an avalanche gain M, in addition to the transistor gain β and the optical/electrical conversion gain Gopt, multiplying the photocurrent in the event of an application of the negative voltage difference between the base electrode and the collection electrode;
   the injection layer being suitable for facilitating the transport of charges between the avalanche layer and the collection layer.

2. The phototransistor according to the preceding claim, wherein the emitter electrode is made of InGaAs or InGaAsP or Si and has a doping density between $0.5 \times 10^{18}$ cm$^{-3}$ and $1.5 \times 10^{19}$ cm$^{-3}$ and a thickness between 50 nm and 120 nm.

3. The phototransistor according to any one of the preceding claims, wherein the emitter layer is made of InP or GaInAsP or AlGaInAs or Si, has a doping density between $0.5 \times 10^{16}$ cm$^{-3}$ and $1.5 \times 10^{17}$ cm$^{-3}$ and a thickness between 120 nm and 180 nm.

4. The phototransistor according to any one of the preceding claims, wherein the base layer is made of InGaAs, SiGe or Si, has a doping density between $0.5 \times 10^{18}$ cm$^{-3}$ and $1.5 \times 10^{19}$ cm$^{-3}$ and a thickness between 40 nm and 100 nm.

5. The phototransistor according to any one of the preceding claims, wherein the graded layer is made of InGaAlAs or InGaAsP or Si, has a doping density between $0.5 \times 10^{18}$ cm$^{-3}$ and $1.5 \times 10^{18}$ cm$^{-3}$ and a thickness between 40 nm and 100 nm.

6. The phototransistor according to any one of the preceding claims, wherein the screen layer is made of InAlAs or Si or InP, has a doping density between $0.5 \times 10^{17}$ cm$^{-3}$ and $1.5 \times 10^{18}$ cm$^{-3}$ and a thickness between 40 nm and 60 nm.

7. The phototransistor according to any one of the preceding claims, wherein the avalanche layer is made of InAlAs or Si or InAlGaAs and has a thickness between 160 nm and 500 nm.

8. The phototransistor according to any one of the preceding claims, wherein the injection layer is made of InAlAs or Si or InAlGaAs, has a doping density between $0.5 \times 10^{17}$ cm$^{-3}$ and $1.5 \times 10^{18}$ cm$^{-3}$ and a thickness between 4 nm and 6 nm.

9. The phototransistor according to any one of the preceding claims, wherein the injection layer is made of InGaAsP, InGaAlAs, InP or SiGe, has a doping density between $10^{15}$ cm$^{-3}$ and $10^{16}$ cm$^{-3}$ and a thickness between 800 nm and 1200 nm.

10. The phototransistor according to any one of the preceding claims, wherein the sub-collection layer is made of InP or Si, has a doping density between $10^{18}$ cm$^{-3}$ and $10^{19}$ cm$^{-3}$ and a thickness between 400 nm and 600 nm.

[Fig.1]

Figure 1

[Fig.2]

Figure 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP H05275730 A

**Littérature non-brevet citée dans la description**

- **MAGNIN, V. et al.** A three-terminal edge-coupled In-GaAs/InP heterojunction phototransistor for multifunction operation. *Microwave and Optical Technology Letters,* 1998, vol. 17 (6), 408-412

- **PRAKASH, D. P et al.** Integration of polyimide waveguides with traveling-wave phototransistors. *IEEE Photonics Technology Letters,* 1997, vol. 9 (6), 802
- **CAMPBELL, J. et al.** Avalanche InP/InGaAs heterojunction phototransistor. *IEEE Journal of Quantum Electronics,* 1983, vol. 19 (6), 1134-1138